# EUROPEAN PATENT SPECIFICATION

(11) **EP 1 542 517 B1**
(45) Date of publication and mention of the grant of the patent: **18.07.2007**
(21) Application number: 04257242.0
(22) Date of filing: 22.11.2004
(51) Int. Cl.: H05K 1/11, H05K 3/34

(54) **Printed Circuit Board for Mounting a Quad Flat Package IC, Method of Soldering a Quad Flat Package IC, and Air Conditioning Apparatus with such a Printed Circuit Board**
Leiterplatte für die Montage einer integrierten Schaltung mit QFP Gehäuse, Verfahren zum Löten einer integrierten Schaltung mit QFP Gehäuse sowie Klimaanlage mit solcher Leiterplatte
Circuit imprimé pour le montage d'un circuit integré en boîtier QFP, procédé de brasage d'un circuit integré en boîtier QFP et appareil de climatisation comportant un tel circuit imprimé

(30) Priority: 11.12.2003 JP 2003412757
(43) Date of publication of application: 15.06.2005
(73) Proprietor: MITSUBISHI DENKI KABUSHIKI KAISHA, Chiyoda-ku Tokyo 100-8310 (JP)
(72) Inventor: Miura, Tsuyoshi c/o Mitsubishi Denki K. K., Tokyo, 100-8310 (JP); Fukushima, Hironobu c/o Mitsubishi Denki K. K., Tokyo, 100-8310 (JP); Mori, Hideki c/o Mitsubishi Denki K. K., Tokyo, 100-8310 (JP)
(74) Representative: Nicholls, Michael John

(56) References cited:
- US-A- 4 544 238
- US-A1- 2003 156 391
- PATENT ABSTRACTS OF JAPAN vol. 2002, no. 04, 4 August 2002 (2002-08-04) & JP 2001 352159 A (CANON INC), 21 December 2001 (2001-12-21)
- PATENT ABSTRACTS OF JAPAN vol. 1999, no. 14, 22 December 1999 (1999-12-22) & JP 11 251725 A (MITSUBA CORP), 17 September 1999 (1999-09-17)

## Description

The present invention relates to a printed circuit board on which a quad-directional-lead flat-package IC (Integrated Circuit) is mounted by soldering using a flow-soldering bath.

Generally, because more populated mounted-components density on a printed circuit board is increasingly required, board-mounting of narrow-pitch quad-directional-lead flat-package ICs or the like is necessary. On the other hand, there is an urgent need to implement the use of environment-friendly lead-free solder. However, lead-free solder has worse solderability than conventionally used lead-eutectic solder. Accordingly, shorting caused by the solder between lead terminals of a quad-directional-lead flat-package IC or the like has occurred.

Conventionally, in a printed circuit board of this type, in order to prevent generation of solder bridges, lateral solder-drawing lands have the shape of a right-angle isosceles triangle that has two sides being approximately the same width as, and being, respectively, approximately parallel to, and perpendicular to, the narrow sides of forward soldering land groups, and one side being parallel to the solder dipping direction; and a rearward solder-drawing land has the shape of a square that has four sides being approximately the same width as, and approximately parallel to, the narrow sides of rearward soldering land groups (e.g., see patent document 1).

Moreover, a technique is disclosed in which chip resistors as electric components are disposed in both lateral corners behind the forward soldering land groups, and a solder-drawing land is provided in the rear corner behind the soldering land groups in the rear side with respect to the soldering flow advance direction (e.g., see patent document 2).

Furthermore, another technique is disclosed in which holes are provided in the lateral solder-drawing lands behind the forward soldering land groups and in the rear solder-drawing land, and an eyelet is disposed in each of the holes (e.g., see patent document 3).
Patent document 1: Japanese Patent Publication No. 2635323 (Pages 3 and 4, and Figs. 1 through 4)
Patent document 2: Japanese Laid-open Patent Publication 352159/2001 (Page 3, and Figs. 1 and 2)
Patent document 3: Japanese Laid-open Patent Publication 242067/H08 (Page 3 and Fig. 1)

In the conventional quad-directional-lead flat-package IC-mounting printed circuit boards described above, in order to maintain stable and high quality soldering for a quad-directional-lead flat-package IC in which solder bridges between leads are never generated, precise control of manufacturing processes is required. As the lead pitch becomes narrower, and when lead-free solder of bad solderability is used, and as the thickness of the quad-directional-lead flat-package IC increases, it has been more difficult to maintain accurate precision.

The present invention is made in consideration of the problem described above, and aims to provide a printed circuit board that, even when a narrow-pitch quad-directional-lead flat-package IC is soldered, can prevent solder short circuits between leads more assuredly under easier control, and can prevent soldering defects from being generated.

Accordingly the present invention provides a printed circuit board for mounting a quad-directional-lead flat-package IC, the printed circuit board including forward soldering land groups and rearward soldering land groups, characterized in that the printed circuit board comprises:
an eyelet provided in either one of the spaces between each forward soldering land group and its adjacent rearward soldering land group; and
a solder-drawing land provided in the other one of the spaces and/or at the tail-endmost portion of the rearward soldering land groups, the solder drawing land having a lattice form.

Another aspect of the invention provides a method of soldering a quad-directional-lead flat package IC, by mounting the quad-directional-lead flat package IC on a surface of a printed circuit board including forward soldering land groups rearward soldering land groups, the method comprising the steps of:
mounting the quad-directional-lead flat package IC, on the surface of the printed circuit board;
applying a flux activator to the reverse face of the printed circuit board on which the quad-directional-lead flat package IC is mounted;
preheating the flux activator to an activation temperature;
soldering lead portions of the quad-directional-lead flat package IC by a flow soldering apparatus; and
removing solder that has bridged between leads of the quad-directional-lead flat package IC with an eyelet and a solder-drawing land having a lattice form, the eyelet being provided in either one of the spaces between each forward soldering land group and its adjacent rearward soldering land group, the solder-drawing land provided in the other one of the spaces and its adjacent rearward soldering land group and/or at the tail-endmost portion of the rearward soldering land groups.

According to another aspect of the invention an air conditioning apparatus includes an outdoor unit, characterized in that the outdoor unit comprises:
an electric parts compartment arranged in an upper portion of a compressor chamber wherein the electric parts compartment contains a printed circuit board according to claim 1.

In the quad-directional-lead flat-package IC-mounting printed circuit board of the present invention, by arranging the solder-drawing land in either one of the spaces between each forward soldering land group and each rearward soldering land group, and/or at the tail-endmost portion of the rearward soldering land groups, of the quad-directional-lead flat-package IC, having a lattice form parallel to the forward soldering lands and parallel to the rearward soldering lands, solder bridges in the forward soldering land group and the rearward soldering land group on the side in which the lateral solder-drawing land is present can be prevented, and excess solder short circuits between the lands at the tail-endmost portion and the rearward solder-drawing land can be prevented from being generated; by disposing longer rearward lands in the forward soldering land groups than the other lands, solder bridges between leads in the forward soldering land group can be further prevented; and, by disposing the eyelet between the forward soldering land group and the rearward soldering land group in the space in which the lateral solder-drawing land is not present, solder bridges in the forward soldering land group can be prevented.

Moreover, in the method of soldering a quad-directional-lead flat-package IC mounted and attached to the printed circuit board according to the invention, the surface/boundary tension of the solder, which has once been sucked in the one lateral solder-drawing land and in the rearward solder-drawing land, is dispersed so that the force drawing the solder back to the forward soldering land group and to the rearward soldering land groups decreases. Consequently, the solder bridges in the forward soldering land group and the rearward soldering land groups substantially diminish in number, and there is a benefit in that operating efficiency is enhanced without increasing fixing work in post processes.

Furthermore, an air conditioning apparatus including a quad-directional-lead flat-package IC-mounting printed circuit board includes: an outdoor unit of the air conditioning apparatus configured with a fan chamber and a compressor chamber; an electric parts compartment arranged in the upper portion of the compressor chamber, the electric parts compartment being flat in form; and a quad-directional-lead flat-package IC-mounting printed circuit board being disposed in the flat compartment; wherein the printed circuit board whose face on which a quad-directional-lead flat-package IC has been disposed is attached by soldering using a flow-soldering bath; a solder-drawing land having a lattice form is provided in either one of the spaces between each forward soldering land group and its adjacent rearward soldering land group, and/or at the tail-endmost portion of the rearward soldering land groups; and an eyelet is provided in the other one of the spaces between each forward soldering land group and its adjacent rearward soldering land group; whereby there are benefits in that the layout space can be made compact by flattening the electric parts compartment in the compressor chamber of the outdoor unit of the air conditioning apparatus, that the flexibility in locating spaces for other parts is increased, and that the assembly work can be carried out with enough room.

The invention will be further described by way of example with reference to the accompanying drawings, in which:-
Fig. 1 is a plan view illustrating a schematic configuration from the rearside of the quad-directional-lead flat-package IC-mounting printed circuit board according to Embodiment 1 of the invention.
Fig. 2 is a plan view illustrating essential parts of the quad-directional-lead flat-package IC-mounting printed circuit board according to Embodiment 1 of the invention.
Fig. 3 is an enlarged plan view of required members, illustrating the relationship on one side, between a forward soldering land group and a rearward soldering land group, of the quad-directional-lead flat-package IC-mounting printed circuit board according to Embodiment 1 of the invention.
Fig. 4 is an enlarged plan view of required members, illustrating the relationship on the other side, between a forward soldering land group and a rearward soldering land group, of the quad-directional-lead flat-package IC-mounting printed circuit board according to Embodiment 1 of the invention.
Fig. 5 is an enlarged plan view of required members, illustrating the relationship between the rearward soldering land groups and a rearward solder-drawing land of the quad-directional-lead flat-package IC-mounting printed circuit board according to Embodiment 1 of the invention.
Fig. 6 is a flowchart illustrating processes for a flow soldering operation for the quad-directional-lead flat-package IC-mounting printed circuit board according to Embodiment 1 of the invention.
Fig. 7 is a plan view illustrating required members of a quad-directional-lead flat-package IC-mounting printed circuit board according to Embodiment 2 of the invention.
Fig. 8 is a plan view illustrating required members of a quad-directional-lead flat-package IC-mounting printed circuit board according to Embodiment 3 of the invention.
Fig. 9 is an enlarged plan view of required members, illustrating the relationship on one side, between the forward soldering land group and the rearward soldering land group, of the quad-directional-lead flat-package IC-mounting printed circuit board according to Embodiment 3 of the invention;
Fig. 10 is an enlarged plan view of required members, illustrating the relationship between the rearward soldering land groups and the rearward solder-drawing land of the quad-directional-lead flat-package IC-mounting printed circuit board according to Embodiment 3 of the invention.
Fig. 11 is a plan view illustrating required members of a quad-directional-lead flat-package IC-mounting printed circuit board according to Embodiment 4 of the invention.
Fig. 12 is a schematic front view illustrating an air conditioning apparatus, in which a quad-directional-lead flat-package IC-mounting printed circuit board is installed, according to Embodiment 5 of the invention.

### Embodiment 1.

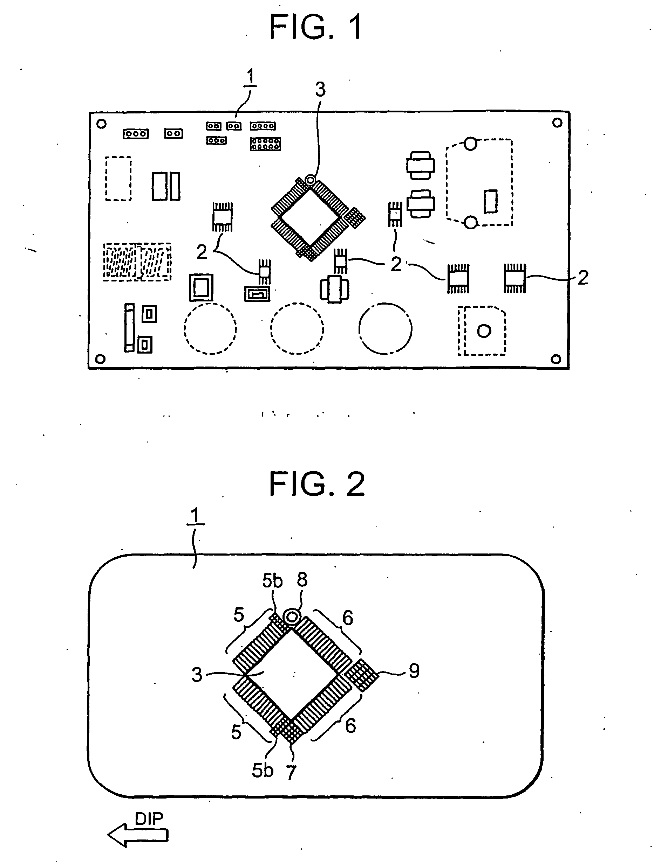

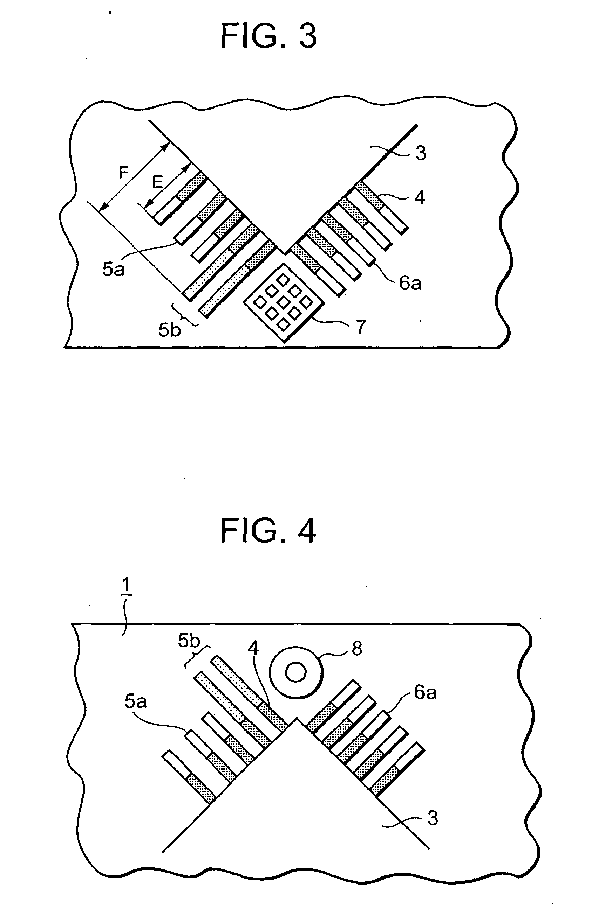

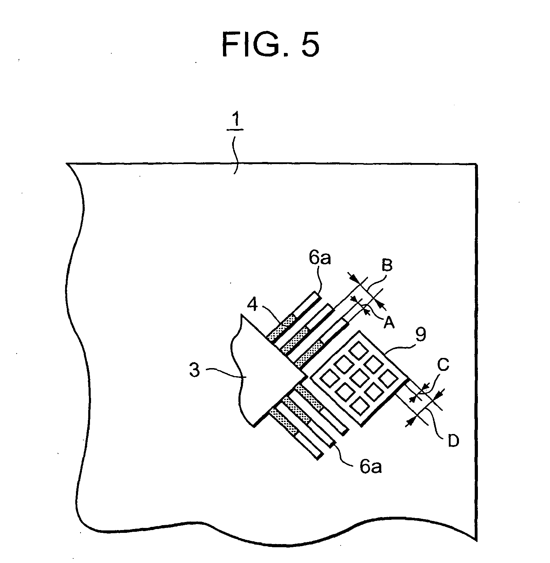

Hereinafter, a quad-directional-lead flat-package IC-mounting printed circuit board according to Embodiment 1 of the present invention will be described using Fig. 1 through Fig. 4. Here, Fig. 1 is a plan view illustrating a schematic configuration from the rearside of the quad-directional-lead flat-package IC-mounting printed circuit board according to Embodiment 1 of the invention; Fig. 2 is a plan view illustrating the quad-directional-lead flat-package IC according to Embodiment 1 of the invention; Fig. 3 is an enlarged plan view of required members, illustrating the relationship on one side, between a forward soldering land group and a rearward soldering land group, of the quad-directional-lead flat-package IC-mounting printed circuit board according to Embodiment 1 of the invention; Fig. 4 is an enlarged plan view of required members, illustrating the relationship on the other side, between a forward soldering land group and a rearward soldering land group, of the quad-directional-lead flat-package IC-mounting printed circuit board according to Embodiment 1 of the invention; and Fig. 5 is an enlarged plan view of required members, illustrating the relationship between the rearward soldering land groups and a rearward solder-drawing land of the quad-directional-lead flat-package IC-mounting printed circuit board according to Embodiment 1 of the invention.

In Fig. 1, on the printed circuit board 1, components that are automatically mounted on the front face (e.g., a chip resistor, a chip capacitor, a chip diode, a discrete resistor, a discrete capacitor, a discrete diode, etc.), and components that are inserted manually (e.g., a large resistor, a hybrid IC, a transformer, a coil, a large-capacity semiconductor, a large capacitor, etc.)-none of these is illustrated in the figure-are disposed.

In addition, on the reverse face of the printed circuit board 1, lined with a copper foil (not illustrated), in order to keep the reverse face planar to a maximum extent, SOP (Small Outline Package) ICs 2, that are automatically mounted, are disposed, and a quad-directional-lead flat-package IC 3 is mounted and attached by means of an automatic mounting machine so that the IC is angled at 45 degrees with respect to the direction indicated by an arrow, namely, to the flow soldering advance direction so that a corner will be at the head end and the diagonal corner will be at the tail end.

For the quad-directional-lead flat-package IC 3, both side forward soldering land groups 5 shaping the head corner and rearward soldering land groups 6 shaping the tail end corner, being formed corresponding to leads 4, are provided; in the rear portion of the forward soldering land groups 5, rearward lands 5b, which have been made longer than the other soldering lands 5a, in the forward soldering land groups are disposed; and a lateral solder-drawing land 7 having a lattice form and formed parallel to the forward soldering lands 5a and parallel to the rearward soldering lands 6a, is disposed in either one of the spaces between each forward soldering land group 5 and its adjacent rearward soldering land group, and an eyelet member 8 is disposed in the other one of the spaces between each forward soldering land group 5 and its adjacent rearward soldering land group. Furthermore, a rearward solder-drawing land 9 having a lattice form and formed parallel to the forward soldering lands 5a and parallel to the rearward soldering lands 6a, is likewise disposed rearward of the both side rearward soldering land groups 6 shaping the tail end corner.

The printed circuit board 1 according to Embodiment 1 of the invention is characterized by the difference between the shape and arrangement of the rearward solder-drawing land, the rearward lands in the forward soldering land groups, and the lateral solder-drawing lands in the printed circuit board in the conventional techniques, and the shape of the lateral solder-drawing lands and the rearward solder-drawing land circuit, the shape of the rearward lands in the forward soldering land groups, and the arrangement of the eyelet disposed between the forward soldering land group and the rearward soldering land group in the printed circuit board of Embodiment 1.

More specifically, the solder-drawing land 7 on one side and the rearward solder-drawing land 9 in the printed circuit board 1 according to Embodiment 1 of the invention are arranged in a lattice-shape, being formed parallel to the forward soldering lands 5a and parallel to the rearward soldering lands 6a, as illustrated in Fig. 2 and Fig. 5; for instance, a lattice-shaped solder-drawing land is formed so that the width A of the leads 6a of the IC 2 is 0.35 mm, the lead pitch B of the IC is 0.65 mm, the lattice pitch D is within 0.65 mm, and the distance C between the adjacent lattice spaces is within 0.3 mm.

In addition, the rearward lands 5b in the forward soldering land groups are longer than the other soldering lands as illustrated in Fig. 3. More specifically, the length F of the rearward lands 5b in the forward soldering land groups is larger than the length E of the forward soldering lands 5a, for example, 3.3 mm ≤ E < F ≤ 5.0 mm.

Moreover, the eyelet member 8 is disposed between the forward soldering land group 5 and the rearward soldering land group 6.

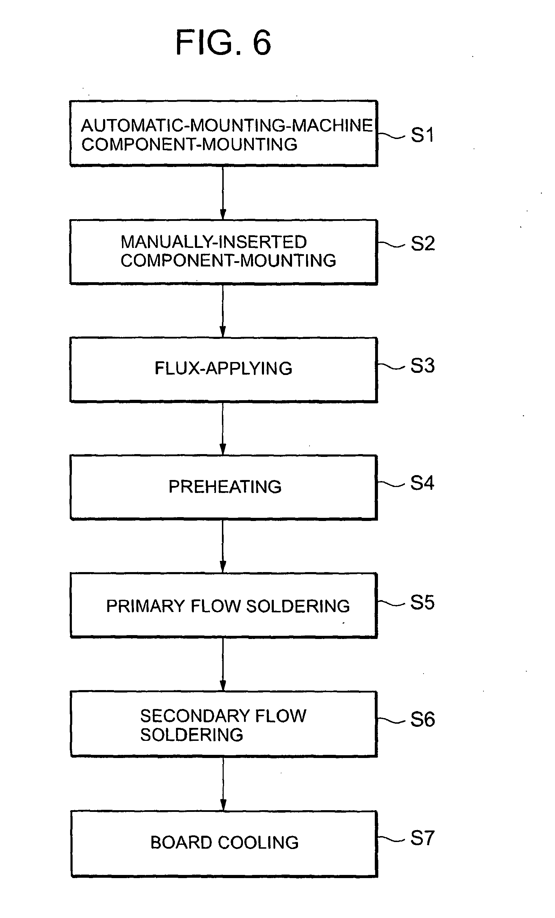

Next, Fig. 6 is a flowchart illustrating processes for a flow soldering operation for the quad-directional-lead flat-package IC; and the soldering, using a flow-soldering bath, of the quad-directional-lead flat-package IC 3 in the printed circuit board 1 configured as described in Fig. 6 will be described. Firstly, in Embodiment 1 of the invention, according to experiment and analysis, on the front face and the reverse face of the printed circuit board 1, in an automatic-mounting-machine component-mounting step in step S1, automatically-mounted components (e.g., a chip resistor, a chip capacitor, a chip diode, a discrete resistor, a discrete capacitor, a discrete diode, etc.)-not illustrated in the figures-and the quad-directional-lead flat-package IC 3 are mounted by means of the automatic mounting machine. Next, in a manually-inserted component-mounting step in step S2, manually-inserted components (e.g., a large resistor, a hybrid IC, a transformer, a coil, a large-capacity semiconductor, a large capacitor, etc.) are manually inserted and attached. Next, in a flux-applying step in step S3, a flux activator is applied to the reverse face of the quad-directional-lead flat-package IC printed circuit board 1 so that the solder can fit the copper foil. Then, in a preheating step in step S4, the flux that was applied in step S3 is heated so as to reach the best activation temperature.

After that, in a primary flow soldering step in step S5, a solder-spurting means for spurting solder like fountain water from a nozzle with a number of holes solders equally all around lead portions of the components on the reverse face of the quad-directional-lead flat-package IC-mounting printed circuit board 1. When the primary flow soldering step in step S5 is completed, in a secondary flow soldering step in step S6, solder that has bridged between leads of components in the primary flow soldering step is removed by the printed board being passed, in the direction of the arrow illustrated in Fig. 2, across the liquid surface of a soldering bath having a flat liquid surface of the solder. Finally, in board cooling in step S7, when the quad-directional-lead flat-package IC-mounting printed circuit board 1 that has been soldered is cooled, then the processes are completed.

When the quad-directional-lead flat-package IC 3 that has been mounted is proceeding into the solder spurting portion in the flow-soldering bath, the solder flows rearwards along the forward soldering leads 4 on both sides, namely, along the forward soldering lands 5a on both sides, of the quad-directional-lead flat-package IC 3. On this occasion, the solder moves rearwards while making bridges in sequence due to action of surface/boundary tension between the soldering lands 5a in the forward soldering land groups 5 and the respective leads 4 of the quad-directional-lead flat-package IC 3. The solder in the rear portion of the forward soldering land group 5 is sucked in the lateral solder-drawing land 7 on one side, and the solder in the rear portion of the rearward soldering land groups 6 is sucked in the rearward solder-drawing land 9. On this occasion, the solder on the lateral solder-drawing land 7 on one side and the solder on the rearward solder-drawing land 9, which has once been sucked, is subjected to force due to action of surface/boundary tension of the solder, which draws the solder back to the forward soldering land group 5 and to the rearward soldering land groups 6, respectively.

Here, by arranging the lateral solder-drawing land 7 on one side and the rearward solder-drawing land 9, as proposed in Embodiment 1, in a lattice-shape, parallel to the forward soldering lands 5a and parallel to the rearward soldering lands 6a, the solder is likely to be sucked in the lateral solder-drawing land 7 on one side and the rearward solder-drawing land 9; and the surface/boundary tension of the solder, which has once been sucked in the lateral solder-drawing land 7 on one side and in the rearward solder-drawing land 9, is dispersed so that the force drawing the solder back to the forward soldering land group 5 and to the rearward soldering land groups 6 decreases. Consequently, the solder bridges in the forward soldering land group 5 and the rearward soldering land groups 6 substantially diminish in number. It is confirmed by the inventor that, if the lateral solder-drawing land 7 on one side and the rearward solder-drawing land 9 are not arranged in a lattice-shape, but are formed to be even lands as in the conventional embodiment, in cases in which a quad-directional-lead flat-package IC having narrow lead gaps, a quad-directional-lead flat-package IC with a thick package, or lead-free solder, which has high surface/boundary tension, are used, much more solder short circuits are generated in the forward soldering land group 5 and in the rearward soldering land groups 6 compared with this embodiment of the invention.

In addition, it is verified that forming the rearward lands 5b in the forward soldering land group 5 for the quad-directional-lead flat-package IC 3 to be longer than other soldering lands 5a makes the sucking force large, and makes the effect of diminishing the solder short circuits larger accordingly.

Moreover, by disposing an eyelet in one of the spaces between each forward soldering land group 5 and each rearward soldering land group 6, in which the lateral solder-drawing land 7 for the quad-directional-lead flat-package IC 3 is not present, the solder that has flowed across the forward soldering land group 5 is strongly sucked in by the eyelet 8, and solder bridges in the forward soldering land group 5 can be substantially diminished. It is verified by experiment that, by disposing an eyelet 8 rearward of the forward soldering land group 5, solder bridges in the forward soldering land group 5 can be eliminated more assuredly.

### Embodiment 2.

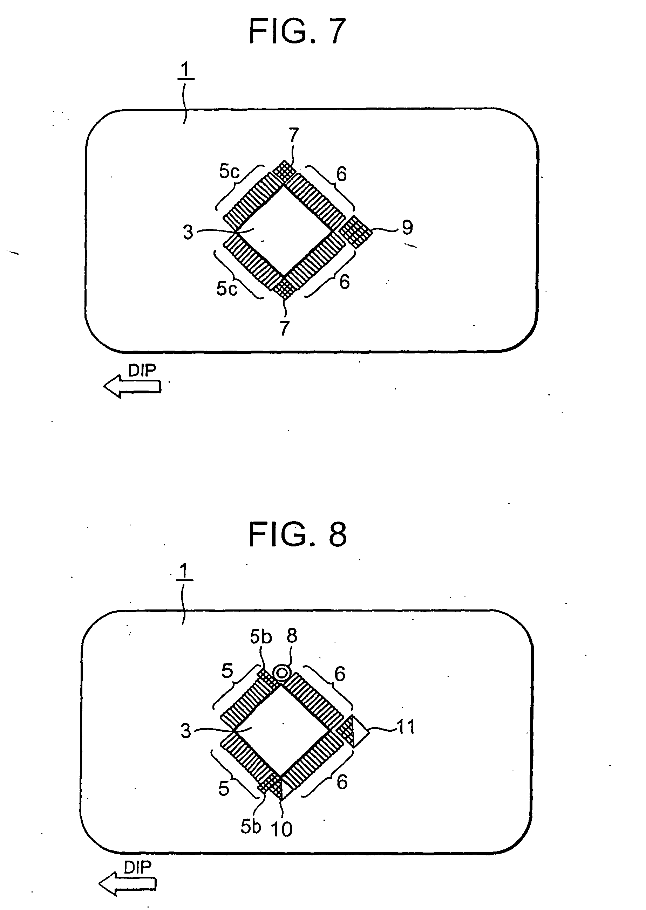

Next, Fig. 7 is a plan view illustrating a quad-directional-lead flat-package IC according to Embodiment 2 of the invention. In the figure, for the quad-directional-lead flat-package IC 3, both side forward soldering land groups 5c that shape the head corner and consist of same-length soldering lands 5a, and rearward soldering land groups 6 that shape the tail end corner, being formed corresponding to leads 4, are provided; a pair of lattice-shaped solder-drawing lands 7 consisting of a latticed surface formed parallel to the forward soldering lands 5a and parallel to the rearward soldering lands 6a are provided in both spaces between the both side forward soldering land groups 5c and the rearward soldering land groups 6; and a lattice-shaped rearward solder-drawing land 9 consisting of a latticed surface likewise formed parallel to the forward soldering lands 5a and parallel to the rearward soldering lands 6a is provided behind the both side rearward soldering land groups 6 shaping the tail end corner.

On the quad-directional-lead flat-package IC-mounting printed circuit board according to Embodiment 2, by arranging the both side lateral solder-drawing lands 7 and the rearward solder-drawing land 9, being in a lattice-shape parallel to the forward soldering lands 5a and parallel to the rearward soldering lands 6a, the solder is likely to be sucked in the both side lateral solder-drawing lands 7 and the rearward solder-drawing land 9; and the surface/boundary tension of the solder, which has once been sucked in the both side lateral solder-drawing lands 7 and in the rearward solder-drawing land 9, is dispersed so that the force drawing the solder back to the forward soldering land groups 5c and to the rearward soldering land groups 6 decreases. Consequently, there is a benefit in that the solder short circuits in the forward soldering land groups 5c and the rearward soldering land groups 6 substantially diminish in number.

### Embodiment 3.

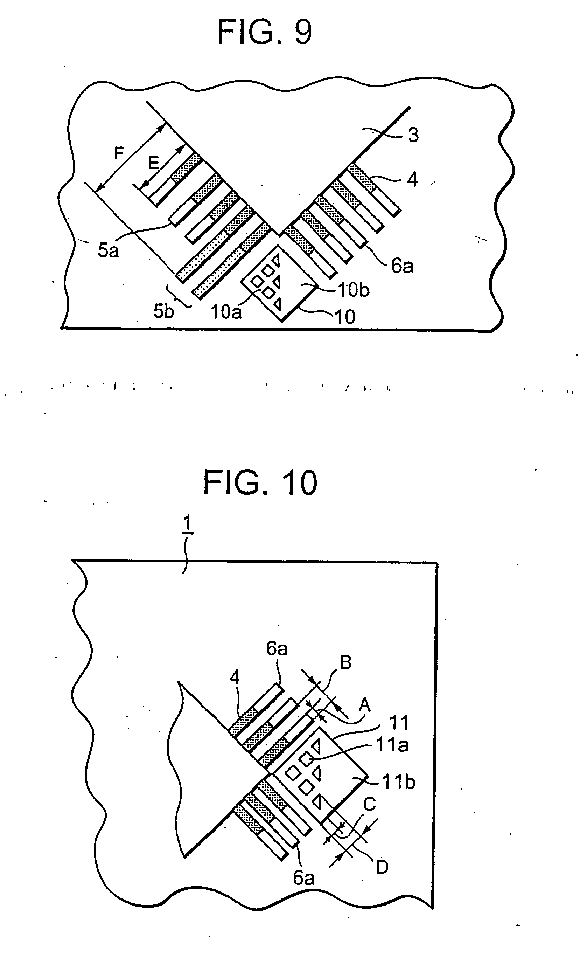

Next, another embodiment of the invention, illustrated in Fig. 8 through Fig. 10, will be described. Fig. 8 is a plan view illustrating a quad-directional-lead flat-package IC according to Embodiment 3 of the invention; Fig. 9 is an enlarged plan view of required members, illustrating the relationship on one side, between the forward soldering land group and the rearward soldering land group on the quad-directional-lead flat-package IC-mounting printed circuit board according to Embodiment 3 of the invention; and Fig. 10 is an enlarged plan view of required members, illustrating the relationship between the rearward soldering land groups and the rearward solder-drawing land on the quad-directional-lead flat-package IC-mounting printed circuit board according to Embodiment 3 of the invention. In the figures, for the quad-directional-lead flat-package IC 3, both side forward soldering land groups 5 shaping the head corner, and rearward soldering land groups 6 shaping the tail end corner, being formed corresponding to leads 4, are provided; rearward lands 5b-being longer than the other soldering lands 5a-in the forward soldering land groups are disposed in the rear portion of the forward soldering land groups 5; a void-free solder-drawing land 10 whose front end is a latticed surface 10a that is an isosceles triangle in shape, and is formed parallel to the forward soldering lands 5a and parallel to the rearward soldering lands 6a, and whose rear end is a smooth surface 10b that is an inverted isosceles triangle in shape, is provided in either one of the spaces between each forward soldering land group 5 and each rearward soldering land group 6; and a void-free rearward solder-drawing land 11 whose front end is a latticed surface 11a that is likewise formed parallel to the forward soldering lands 5a and parallel to the rearward soldering lands 6a, and whose rear end is a smooth surface 11b that is an inverted isosceles triangle in shape, is provided rearward of both side rearward soldering land groups 6 shaping the tail end corner.

According to the quad-directional-lead flat-package IC-mounting printed circuit board in Embodiment 3 of the invention, it has been confirmed, as a result of a trial production and its evaluation, that preventing void solder chips from being generated by providing the lateral and rearward void-free solder-drawing lands has a further benefit; it is made possible to eliminate manual fixing work for removing voids in later processes, and there is a benefit in that cutting out processes can be realized.

### Embodiment 4.

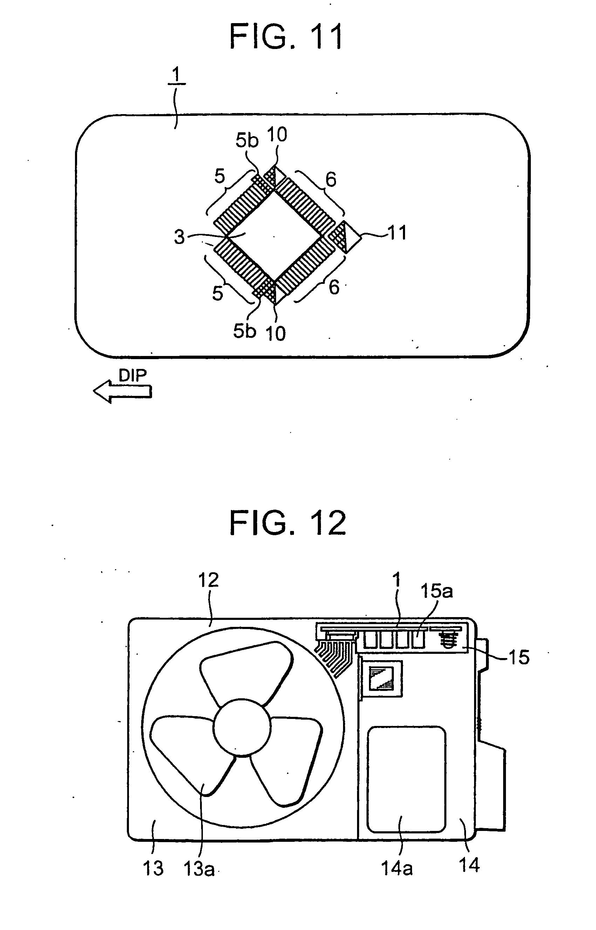

Fig. 11 is a plan view illustrating a quad-directional-lead flat-package IC according to Embodiment 4 of the invention. In the figure, for the quad-directional-lead flat-package IC 3, both side forward soldering land groups 5, being formed corresponding to leads 4, and shaping the head corner, are provided, in the rear portion of which rearward lands 5b-being longer than the other soldering lands 5a-in the forward soldering land groups are disposed; rearward soldering land groups 6 that shapes the tail end corner are provided; void-free solder-drawing lands 10 whose front end is a latticed surface 10a that is an isosceles triangle in shape, and formed parallel to the forward soldering lands 5a and parallel to the rearward soldering lands 6a, and whose rear end is a smooth surface 10b that is an inverted isosceles triangle in shape, are provided in both spaces between each forward soldering land group 5 and each rearward soldering land group 6; and a void-free rearward solder-drawing land 11 whose front end is a latticed surface 11a that is likewise formed parallel to the forward soldering lands 5a and parallel to the rearward soldering lands 6a, and whose rear end is a smooth surface 11b that is an inverted isosceles triangle in shape, is provided rearward of the both side rearward soldering land groups 6 shaping the tail end corner.

According to the quad-directional-lead flat-package IC-mounting printed circuit board in Embodiment 4 of the invention, it has been confirmed, as a result of a trial production and its evaluation, that preventing void solder chips from being generated by providing the lateral and rearward void-free solder-drawing lands has a further benefit; it is made possible to eliminate manual fixing work for removing voids in later processes, and there is a benefit in that cutting out processes can be realized.

As described above, according to the quad- directional- lead flat-package IC-mounting printed circuit board of the invention, benefits can be achieved in that, by using the flow-soldering bath, when soldering a quad-directional-lead flat-package IC, solder short circuits that are generated by the solder moving rearwards while creating bridges due to surface/boundary tension can be eliminated more assuredly, and that the number of points in which solder short circuits are generated can be reduced. In addition, reducing the area of the solder-drawing lands can be realized, and efficient pattern designing can be available.

### Embodiment 5.

Fig. 12 is a schematic front view illustrating an outdoor unit of an air conditioning apparatus, in which a quad-directional-lead flat-package IC-mounting printed circuit board according to the other embodiments of the invention is installed. In the figure, the outdoor unit 12 of an air conditioning apparatus is configured with a fan chamber 13 equipped with a fan 13a, a compressor chamber 14 including a compressor 14a and an electric parts compartment 15 that is flat in form; and the quad-directional-lead flat-package IC-mounting printed circuit board 1 is disposed in the electric parts compartment 15, with its front face on which electric parts 15a are mounted being downward, and with its reverse face that is planer and lined with copper foil being upward.

Accordingly, the electric parts compartment in which the quad-directional-lead flat-package IC-mounting printed circuit board 1 according to the other embodiments of the invention is disposed can be configured to be flat in form in the heightwise orientation, and there are benefits in that the layout space can be made compact by flattening the electric parts compartment in the compressor chamber of the outdoor unit of the air conditioning apparatus, that the flexibility in locating spaces for other parts is increased, and that the assembly work can be carried out with enough room.

## Claims

1. A printed circuit board (1) for mounting a quad-directional-lead flat-package IC (3), the printed circuit board including forward soldering land groups (5) and rearward soldering land groups (6), **characterized in that** the printed circuit board comprises:
an eyelet (8) provided in either one of the spaces between each forward soldering land group (5) and its adjacent rearward soldering land group (6); and
a solder-drawing land (7;9;10;11) provided in the other one of the spaces and/or at the tail-endmost portion of the rearward soldering land groups (6), the solder drawing land having a lattice form.

2. A printed circuit board (1) according to claim 1, wherein rearward lands (5b) in the forward soldering land groups (5) are longer than the other lands in the forward soldering land groups (5).

3. A printed circuit board (1) according to claim 1 or 2, wherein the front part, near to the rearward soldering land groups (6), of the solder drawing land (10;11) has a latticed surface (10a;11a) and the rear part of the solder drawing land has a smoothed surface (10b;11b).

4. A printed circuit board (1) according to claim 1, 2 or 3, wherein the forward (5) and the rearward soldering land groups (6) are angled with respect to the flow soldering advance direction.

5. A method of soldering a quad-directional-lead flat-package IC (3), by mounting the quad-directional-lead flat-package IC on a surface of a printed circuit board including forward soldering land groups (5) and rearward soldering land groups (6), the method comprising the steps of:
mounting (S2) the quad-directional-lead flat-package IC, on the surface of the printed circuit board;
applying (S3) a flux activator to the reverse face of the printed circuit board on which the quad-directional-lead flat-package IC (3) is mounted;
preheating (S4) the flux activator to an activation temperature;
soldering (SS;S6) lead portions of the quad-directional-lead flat-package IC (3) by a flow soldering apparatus; and
removing solder that has bridged between leads of the quad-directional-lead flat-package IC with an eyelet (8) and a solder-drawing land (7;9;10;11) having a lattice form (10a;11a), the eyelet (8) being provided in either one of the spaces between each forward soldering land group (5) and its adjacent rearward soldering land group (6), the solder-drawing land (7;9;10;11) provided in the other one of the spaces and its adjacent rearward soldering land group (6) and/or at the tail-endmost portion of the rearward soldering land groups (6).

6. A method according to claim 5, **characterized in that** the quad-directional-lead flat-package IC(3) is carried above a flow soldering bath in order to be soldered in a flow soldering advance direction, the second corner being formed from edges of the rearward soldering land groups (6), the forward (5) and the rearward soldering land groups (6) being angled with respect to the flow soldering advance direction.

7. An air conditioning apparatus including an outdoor unit (12), **characterized in that** the outdoor unit comprises:
an electric parts compartment (15) arranged in an upper portion of a compressor chamber (14) wherein the electric parts compartment (15) contains a printed circuit board (1) according to any one of claims 1, 2, 3 or 4.

## Patentansprüche

1. Leiterplatte (1) für die Montage einer integrierten Schaltung mit QFP-Gehäuse (3), wobei die Leiterplatte Vorwärtslötanschlussgruppen (5) und Rückwärtslötanschlussgruppen (6) enthält, **dadurch gekennzeichnet, dass** die Leiterplatte aufweist:
eine Öse (8), die in einem der Räume zwischen jeder Vorwärtslötanschlussgruppe (5) und ihrer benachbarten Rückwärtslötanschlussgruppe (6) vorgesehen ist; und
ein Lötmittel-Ansaugfeld (7; 9; 10; 11), das in dem anderen der Räume und/oder in dem äußersten Endbereich der Rückwärtslötanschlussgruppen (6) vorgesehen ist, wobei das Lötmittel-Ansaugfeld eine Gitterform hat.

2. Leiterplatte (1) nach Anspruch 1, bei der Rückwärtsanschlüsse (5b) in den Vorwärtslötanschlussgruppen (5) länger als die anderen Anschlüsse in den Vorwärtslötanschlussgruppen (5) sind.

3. Leiterplatte (1) nach Anspruch 1 oder 2, bei der der vordere Teil des Lötmittel-Ansaugfelds (10; 11) nahe den Rückwärtslötanschlussgruppen (6) eine gitterförmige Oberfläche (10a; 11a) hat und der hintere Teil des Lötmittel-Ansaugfelds eine glatte Oberfläche (10b; 11b) hat.

4. Leiterplatte (1) nach Anspruch 1, 2 oder 3, bei der die Vorwärts- (5) und die Rückwärtslötanschlussgruppen (6) unter einem Winkel mit Bezug auf die Flow-Solder-Vorwärtsfließrichtung verlaufen.

5. Verfahren zum Löten einer integrierten Schaltung mit QFP-Gehäuse (3) durch Montage der integrierten Schaltung mit QFP-Gehäuse auf einer Oberfläche einer Leiterplatte enthaltend Vorwärtslötanschlussgruppen (5) und Rückwärtslötanschlussgruppen (6), welches Verfahren die Schritte aufweist:
Befestigen (S2) der integrierten Schaltung mit QFP-Gehäuse auf der Oberfläche der Leiterplatte; Aufbringen (S3) eines Fließaktivators auf die Rückfläche der Leiterplatte, auf der die integrierte Schaltung mit QFP-Gehäuse (3) befestigt ist;
Vorerwärmen (S4) des Fließaktivators auf eine Aktivierungstemperatur;
Löten (S5; S6) von Leiterbereichen der integrierten Schaltung mit QFP-Gehäuse (3) durch eine Flow-Solder-Vorrichtung; und
Entfernen von Lötmittel, das den Raum zwischen Leitern der integrierten Schaltung mit QFP-Gehäuse (3) überbrückt hat, mit einer Öse (8) und einem Lötmittel-Ansaügfeld (7; 9; 10; 11) mit Gitterform (10a; 11a), wobei die Öse (8) in einem der Räume zwischen jeder Vorwärtslötanschlussgruppe (5) und ihrer benachbarten Rückwärtslötanschlussgruppe (6) vorgesehen ist, das Lötmittel-Ansaugfeld (7; 9; 10; 11) in dem anderen der Räume und seiner benachbarten Rückwärtslötanschlussgruppe (6) und/oder in dem äußersten Endbereich der Rückwärtslötanschlussgruppen (6) vorgesehen ist.

6. Verfahren nach Anspruch 5, **dadurch gekennzeichnet, dass** die integrierte Schaltung mit QFP-Gehäuse (3) oberhalb eines Flow-Solder-Bades getragen wird, um in einer Flow-Solder-Vorwärtsrichtung gelötet zu werden, wobei die zweite Ecke aus Kanten der Rückwärtslötanschlussgruppen (6) gebildet ist und die Vorwärts- (5) und die Rückwärtslötanschlussgruppen (6) unter einem Winkel mit Bezug auf die Flow-Solder-Vorwärtsfließrichtung verlaufen.

7. Klimagerät enthaltend eine Freilufteinheit (12), **dadurch gekennzeichnet, dass** die Freilufteinheit aufweist:
ein Feld (15) für elektrische Teile, das in einem oberen Teil einer Kompressorkammer (14) angeordnet ist, wobei das Feld (15) für elektrische Teile eine Leiterplatte (1) nach einem der Ansprüche 1, 2, 3 oder 4 enthält.

## Revendications

1. Carte de circuit imprimé (1) pour monter un circuit intégré (3) à boîtier plat et à quadruple fil directionnel, la carte de circuit imprimé comprenant des groupes de plages d'accueil de brasage avant (5) et des groupes de plages d'accueil de brasage arrière (6), **caractérisée en ce que** la carte de circuit imprimé comprend :
un oeillet (8) aménagé dans l'un ou l'autre des espaces entre chaque groupe de plages d'accueil de brasage avant (5) et son groupe adjacent de plages d'accueil de brasage arrière (6) ; et
une plage d'accueil de brasure-étirage (7 ; 9 ; 10 ; 11) aménagée dans l'autre des espaces et/ou dans la partie de queue la plus à l'extrémité des groupes de plages d'accueil de brasage arrière (6), la plage d'accueil de brasure-étirage ayant la forme d'un réseau.

2. Carte de circuit imprimé (1) selon la revendication 1, dans laquelle les plages d'accueil arrière (5b) des groupes de plages d'accueil de brasage avant (5) sont plus longs que les autres plages d'accueil des groupes de plages d'accueil de brasage avant (5).

3. Carte de circuit imprimé (1) selon la revendication 1 ou 2, dans laquelle la partie avant, à proximité des groupes de plages d'accueil de brasage arrière (6), de la plage d'accueil de brasure-étirage (10 ; .11) a une surface en réseau (10a; 11a) et la partie arrière de la plage d'accueil de brasure-étirage a une surface lisse (10b ; 11b).

4. Carte de circuit imprimé (1) selon la revendication 1, 2 ou 3, dans laquelle les groupes de plages d'accueil de brasage avant (5) et ceux de plages d'accueil de brasage arrière (6) font un angle avec la direction d'avancement du brasage à la vague.

5. Procédé de brasage d'un circuit intégré (3) à boîtier plat et à quadruple fil directionnel en montant le circuit intégré à boîtier plat et à quadruple fil directionnel sur une surface de carte de circuit imprimé comprenant des groupes de plages d'accueil de brasage avant (5) et des groupes de plages d'accueil de brasage arrière (6), le procédé comprenant les étapes suivantes :
le montage (S2) du circuit intégré à boîtier plat et quadruple fil directionnel sur la surface de la carte de circuit imprimé ;
l'application (S3) d'un activateur de flux au verso de la carte de circuit imprimé sur laquelle est montée le circuit intégré (3) à boîtier plat et quadruple fil directionnel;
le préchauffage (S4) de l'activateur de flux à une température d'activation;
le brasage (S5; S6) de parties de fil du circuit intégré (3) à boîtier plat et quadruple fil directionnel par un appareil de brasage à la vague ; et
l'élimination de la brasure qui s'est pontée entre les fils du circuit intégré à boîtier plat et quadruple fil directionnel avec un oeillet (8) et une plage d'accueil de brasure -étirage (7 ; 9 ; 10 ; 11) ayant la forme d'un réseau (10a ; 11a), l'oeillet (8) étant disposé dans l'un ou l'autre des espaces entre chaque groupe de plages d'accueil de brasage avant (5) et son groupe adjacent de plages d'accueil de brasage arrière (6), la plage d'accueil de brasure-étirage (7; 9; 10; 11) étant aménagée dans l'autre des espaces et son groupe adjacent de plages d'accueil de brasage arrière (6) et/ou dans la partie de queue la plus à l'extrémité des groupes de plages d'accueil de brasage arrière (6).

6. Procédé selon la revendication 5, **caractérisé en ce que** le circuit intégré (3) à boîtier plat et à quadruple fil directionnel est acheminé au-dessus d'un bain de brasage à la vague pour être brasé dans une direction d'avancement de brasage à la vague, le second coin étant formé à partir des bords des groupes de plages d'accueil de brasage arrière (6), les groupes de plages d'accueil de brasage avant (5) et ceux de plages d'accueil de brasage arrière (6) faisant un angle avec la direction d'avancement du brasage à la vague.

7. Appareil de conditionnement d'air comprenant une unité extérieure (12), **caractérisé en ce que** l'unité extérieure comprend :
un compartiment de pièces électriques (15) aménagé dans une partie supérieure d'une chambre de compresseur (14), le compartiment de pièces électriques (15) contenant une carte de circuit imprimé (1) selon l'une quelconque des revendications 1, 2, 3 ou 4.
